# EUROPEAN PATENT SPECIFICATION

(11) **EP 2 408 160 B1**
(45) Date of publication and mention of the grant of the patent: **06.03.2013**
(21) Application number: 10305770.9
(22) Date of filing: 12.07.2010
(51) Int. Cl.: H04L 27/36, H04W 88/08, H04B 10/2575

(54) **A method for transmission of data signals from a transmitting device to a receiving device using envelope tracking for signal amplification, a transmitting device and a receiving device therefor**
Verfahren zur Übertragung von Datensignalen von einer Sendevorrichtung an eine Empfangsvorrichtung mithilfe der Envelope-Verfolgung zur Signalverstärkung, Sendevorrichtung und Empfangsvorrichtung dafür
Procédé de transmission de signaux de données à partir d'un dispositif de transmission vers un dispositif de réception au moyen de suivi d'enveloppe pour l'amplification de signal, dispositif de transmission et dispositif de réception correspondant

(43) Date of publication of application: 18.01.2012
(73) Proprietor: Alcatel Lucent, 75007 Paris (FR)
(72) Inventor: Wiegner, Dirk, 71409, Schwaikheim (DE); Pascht , Andreas, 73635, Rudersberg (DE)
(74) Representative: Kleinbub, Oliver

(56) References cited:
- US-A1- 2007 072 646
- US-A1- 2008 260 066
- US-B1- 6 411 416
- KIMBALL ET AL: "High-Efficiency Envelope-Tracking W-CDMA Base-Station Amplifier Using GaN HFETs", IEEE TRANSACTIONS ON MICROWAVE THEORY AND TECHNIQUES, IEEE SERVICE CENTER, PISCATAWAY, NJ, US, vol. 54, no. 11, 1 November 2006 (2006-11-01), pages 3848-3856, XP011149867, ISSN: 0018-9480, DOI: DOI:10.1109/TMTT.2006.884685

## Description

### Field of the invention

The invention relates to a method for transmission of data signals from a transmitting device to at least one receiving device comprising at least one analogue radio frequency power amplifier using envelope tracking for signal amplification, wherein said data signals are transmitted over at least one optical connection from the transmitting device to the at least one receiving device, a transmitting device and a receiving device adapted to perform said method.

### Background

The coverage of a certain service area in a cellular radio network is provided by several radio base stations, which are connected to a core network to serve connections to and from mobile users within the service area. A radio base station contains a baseband unit and at least one antenna unit. In order to increase radio coverage and capacity, modern base stations use several sector antennas.

In order to increase flexibility of the base stations, it is desirable to allow the antennas to be located remote from the baseband unit. This has lead to the development of active an-tenna systems which are also termed remote antenna heads. Typically, one remote antenna head contains one sector antenna, but there are also systems known, which have remote antenna heads with more than only one sector antenna.

The base stations are preferably connected with the remote antenna heads by means of optical fibers. Conventional radio-over-fiber scenarios involve optical transmission of analogue signals between a base station and a transmitter with an amplifier in a remote antenna head.

In the US patent application publication US 2007/0072646 A1, a wireless base station and communication method therefor are disclosed, said wireless base station comprising a center unit, and a remote unit provided with an array antenna and connected to the center unit through an optical fiber, the center unit outputs to the optical fiber a transmission signal in a baseband state prior to array processing, the remote unit performs the array processing of transmission signals in accordance with array weights and converts the transmission signals into RF signals, thereby to localize the compensation for transmission signal deviations occurring among the antenna elements on the remote unit side.

In the US patent application publication US 2008/0260066 A1, a Dynamic Digital Pre-Distortion (DDPD) system is disclosed to rapidly correct power amplifier (PA) non-linearity and memory effects. Furthermore, a cell site is disclosed with a radio server and radio heads (RH) connected by fiber optic lines, said radio heads (RH) comprising power amplifiers (PA) and DDPD systems. In order to achieve high efficiency in the PA chain, among other approaches envelope tracking is proposed.

In the paper from Kimball et al. with the title "High-Efficiency Envelope Tracking W-CDMA Base-Station Amplifier Using GaN HFETs", IEEE Transactions on Microwave Theory and Techniques, IEEE Service Center, Piscataway, NJ, US, vol. 54, no. 11, 1 November 2006, pages 3848-3856, a high-efficiency wideband code-division multiple-access (W-CDMA) base-station amplifier is presented using high-performance GaN heterostructure field-effect transistors to achieve high gain and efficency with good linearity. For nonconstant envelope input, the average efficiency is further increased by employing the envelope-tracking architecture using a wide-bandwidth high-efficiency envelope amplifier.

An example for the implementation of a radio-over-fiber concept in a cellular radio network using a two-fiber-ring is given in the European patent EP 1553791 B1.

However, the quality of the optical transmission suffers severely from noise, non-linearities, like e.g. chromatic dispersion, and attenuation effects. Additionally, signal transmission over wide distances leads e.g. to high losses. Consequently the technical implementations for radio-over-fiber concepts must involve highly sophisticated optical modulation techniques and signal conditioning.

### Summary

Basically, the optical transmission of analogue radio frequency signals involves high electronic efforts for signal modulation techniques and signal conditioning. Indeed, e.g. the method of intensity modulation and direct detection is straightforward, simple and allows for fairly linear optical transmission properties, but on the other hand it requires costly modulators and modulator drivers in order to meet the requirements for analogue radio frequency transmission. In case double side band modulation is used, chromatic dispersion will result in frequency and length dependent suppression of radio frequency power, which will deteriorate the transmission quality.

Furthermore, as mobile communication systems like e.g. Universal Mobile Telecommunications System (UMTS), Worldwide Interoperability for Microwave Access (WIMAX), or Third Generation Partnership Project Long Term Evolution (3GPP LTE) require power amplifiers with high output power at frequencies up to 2.6 GHz, so-called envelope tracking amplifiers seem advantageous for signal amplification, as they feature a high degree of linearity and efficiency.

In said envelope tracking amplifiers, the data signal is represented by an envelope signal component of relatively slowly varying amplitude, and the faster varying complete data signal. The fast varying data signal controls the input of e.g. a class AB output stage, whereas the envelope signal drives a modulator which again controls the supply voltage of said output stage.

The object of the invention is thus to propose an energy-efficient and fault-tolerant method for optical transmission of signals from a transmitting device to a receiving device.

This object is achieved by a method for transmission of data signals from a transmitting device to at least one receiving device according to claim 1.

The object is furthermore achieved by a receiving device according to claim 10.

In other words, in order to address the above-identified problems, it is thus proposed to transmit envelope signal components and data signals from the digital part of a base station digitally via an optical connection, as e.g. an optical fibre, to a distributed, even far remotely located, amplification stage, followed by an antenna network and an antenna. Since the signal transmission over the optical connection is done in the digital domain, the usage of a kind of digital amplifier, as e.g. a so-called class S amplifier, capable of handling digital input signals, would be preferable. However, despite all the benefits of digital amplifier concepts, most of them are currently not yet mature enough to be implemented in a high performing and reliable manner into products in the short-term to mid-term timeframe.

The basic idea of the invention is thus to transmit the envelope signal components and the data signals in a digitally modulated manner over an optical fiber to the distributed amplifier and antenna module, and to perform in the amplifier and antenna module a digital to analog conversion, e.g. simply by a suitable filter in case of delta-sigma or pulse-length modulated signals. Then, a supply voltage is modulated with the analogue envelope signal components in a modulator, and the modulated supply voltage and the analogue data signals can be fed to an analogue amplification stage.

This idea allows transmitting the radio signal to the amplifier also across wide distances with low loss and low signal quality degradation by means of digital data transmission, and to use analogue amplifier solutions, such as conventional class AB, Doherty or Envelope Tracking amplifiers, with most of them already being mature and implemented in products.

The idea further allows for realization of superior radio-over-fiber architecture by dividing e.g. an envelope tracking amplifier into two parts separated by digital optical links and placing them in a central base station and close to a remote antenna unit respectively. This concept enables new architectures which easily reduce costs and hardware effort, e.g. in beamforming and multiple input multiple output (MIMO) applications.

Further developments of the invention can be gathered from the dependent claims and the following description.

In the following the invention will be explained further making reference to the attached drawings.

### Brief description of the figures

Fig. 1 schematically shows a cellular communication network with a base station and remote antenna heads in which the invention can be implemented.
Fig. 2 schematically shows a transmitting device comprising digital modulators linked by two optical connections serving as envelope signal path and data signal path with a receiving device comprising an analogue radio frequency power amplifier according to the invention.
Fig. 3 schematically shows a transmitting device comprising digital modulators linked by a common optical connection serving as both envelope signal path and data signal path with a receiving device comprising an analogue radio frequency power amplifier according to the invention.

### Description of the embodiments

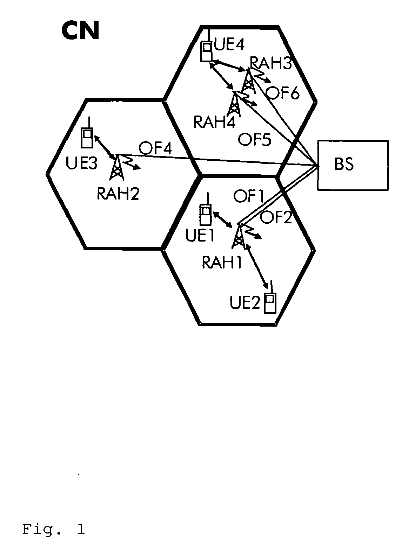

The principle structure of a communication network CN for signal transmission and reception in which the invention can be implemented is shown in fig. 1. The communication network CN comprises a base station BS, remote antenna heads RAH1-RAH4 and user terminals UE1-UE4.

Each of said remote antenna heads RAH1-RAH4 is connected to the base station BS by means of at least one optical connection, as e.g. an optical fiber or an optical free-space connection, OF1, OF2, OF4, OF5 and OF6 respectively. Each of said user terminals UE1-UE4 is connected to one or multiple of said remote antenna heads RAH1-RAH4, which is symbolized by double arrows in fig. 1. The base station BS is in turn connected to a core network, which is not shown in fig. 1 for the sake of simplicity.

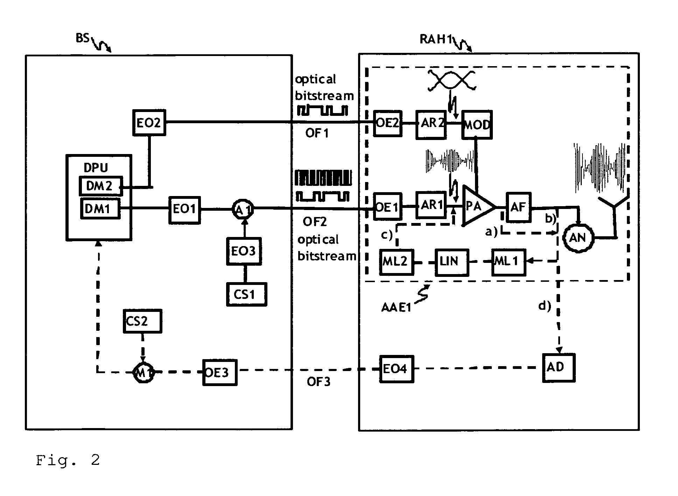

A transmitting device BS, as e.g. a base station, and a receiving device RAH1, as e.g. a remote antenna head, according to an embodiment of the invention is depicted in fig. 2.

The transmitting device BS is indicated as a box and comprises a digital signal processing unit DPU with a first and a second digital modulator DM1 and DM2, a first carrier synthesizer CS1, three electro-optical converters EO1, EO2 and EO3, and an optical adder A1.

The receiving device RAH1 is also indicated as a box and comprises a first and a second opto-electrical converter OE1 and OE2, a first and a second analogue reconstruction device AR1 and AR2, a modulator MOD, an analogue radio frequency power amplifier PA, an antenna filter AF, and an antenna network AN. Said devices together are part of a so-called active antenna element AAE1, which is indicated by a dashed box.

An output of the first digital modulator DM1 is connected to an input of the first electro-optical converter E01, and an output of the second digital modulator DM2 is connected to an input of the second electro-optical converter EO2. An output of the first carrier synthesizer CS1 is connected to an input of the third electro-optical converter EO3. An output of the first electro-optical converter EO1 is connected to a first input of the optical adder A1, and an output of the third electro-optical converter EO3 is connected to a second input of the optical adder A1.

An output of the second electro-optical converter EO2 is connected to an input of the second opto-electrical converter OE2 through an optical connection OF1, as e.g. an optical fiber or an optical free-space connection.

An output of the optical adder A1 is connected to an input of the first opto-electrical converter OE1 through an optical connection OF2, as e.g. an optical fiber or an optical free-space connection.

An output of the first opto-electrical converter OE1 is connected to an input of the first analogue reconstruction device AR1, and an output of the first analogue reconstruction device AR1 is connected to a first input of the analogue radio frequency power amplifier PA.

An output of the second opto-electrical converter OE2 is connected to an input of the second analogue reconstruction device AR2, and an output of the second analogue reconstruction device AR2 is connected to an input of the modulator MOD.

An output of the modulator MOD is connected to a second input of the analogue radio frequency power amplifier PA.

An output of the analogue radio frequency power amplifier PA is connected to an input of the antenna filter AF, and an output of the antenna filter AF is connected to an input of the antenna network AN.

In the digital modulators DM1 and DM2, electrical data signals, as e.g. envelope signal components and data signals of so-called I and Q data used e.g. in the standard Third Generation Partnership Project Long Term Evolution (3GPP LTE), that the digital modulators DM1 and DM2 receive at their input are digitally modulated resulting in electrical digital data signals.

In the embodiment depicted in fig. 2, two digital modulators DM1 and DM2 are shown. However, in other embodiments, a common digital modulator for modulation of the envelope signal components and modulation of the data signals can be used.

The digital modulator can e.g. be a so-called delta sigma modulator or a pulse-length modulator for envelope signal components, or a so-called bandpass delta sigma modulator or a pulse-length modulator for data signals.

An amplitude and phase modulated baseband signal e.g. on a baseband frequency f_{bb} preferably in the frequency range 0-200 MHz is represented by a complex data signal *A*(*t*)exp(*i*(ω*_{bb}t*+φ(*t*))), with *A*(*t*) being the time-dependent amplitude, ω*_{bb}* being the baseband angular frequency, and φ*(t*) being the time-dependent phase.

In the digital signal processing unit DPU, the envelope signal component of slowly varying amplitude *A*(*t*) is created, conditioned, and delay-adjusted with the data signal *A*(*t*)exp(*i*(**ω***_{bb}t*+*φ*(*t*))). Then the conditioned and time-adjusted envelope signal component is converted to a digital signal in the digital modulator DM2, which can be a single-bit modulator, as e.g. a delta sigma or a pulse length modulator. The 1-bit envelope signal component on baseband level is then fed to the input of the second electro-optical converter EO2.

The digital envelope signal component is sent to the second electro-optical converter EO2 for converting digital electrical signals into digital optical signals.

Preferably, said second electro-optical converter EO2 comprises a laser diode which is either directly modulated or externally modulated e.g. by means of an electroabsorption or lithiumniobate modulator.

From the output of the second electro-optical converter E02, the digital optical envelope signal component is sent over the optical connection OF1, which can be e.g. an optical fiber or an optical free-space connection, to the input of the second opto-electrical converter OE2.

In the second opto-electrical converter OE2, digital optical signals are back-converted into digital electrical signals. Preferably, said opto-electrical converter OE2 comprises a so-called PIN-diode or a so-called avalanche-photo-diode.

From the second opto-electrical converter OE2, the resulting digital electrical envelope signal component is sent to the input of the second analogue reconstruction device AR2, in which electrical digital data signals are converted into electrical analogue data signals. Said second analogue reconstruction device AR2 can e.g. be a so-called reconstruction filter in case of delta sigma modulated or pulse width modulated electrical digital data signals.

The resulting analogue electrical envelope signal component is then sent to the input of the modulator MOD.

In the modulator MOD, the analogue electrical envelope signal component drives at least one transistor via at least one driver, which leads to amplified analogue electrical signals at the output of the modulator MOD. Thus, a supply voltage, which is generated or provided in the modulator MOD, is modulated with the analogue electrical envelope signal component resulting in an amplified analogue electrical envelope signal component.

Said amplified analogue electrical envelope signal component is connected as a supply voltage to the second input of the analogue radio frequency power amplifier PA.

Furthermore, in the digital signal processing unit DPU, the data signal on baseband level *A*(*t*)exp(*i*(ω*_{bb}t*+*φ*(*t*))) is converted to a digital signal in the digital modulator DM1, which can be a single-bit modulator, as e.g. a bandpass delta sigma or a pulse length modulator. The 1-bit data signal on baseband level is then fed to the input of the first electro-optical converter EO1.

In the first electro-optical converter EO1, the electrical digital data signal is converted into a digital optical signal using an optical source with f_{optical} being the frequency of the light of the optical source, so that the digital optical data signal has a frequency fₒₛ = f_{optical} ± f_{bb}.

Preferably, said first electro-optical converter EO1 comprises a laser diode which is either directly modulated or externally modulated e.g. by means of an electroabsorption or lithiumniobate modulator.

From the output of the first electro-optical converter EO1, the digital optical data signal is sent over an optical connection to the first input of the optical adder A1.

In the carrier synthesizer CS1, an electrical radio frequency carrier signal, which can be digital or analogue, on a radio frequency f_{rf} preferably in the frequency range of several hundreds of MHz to several GHz is generated. The electrical radio frequency carrier signal is sent to the third electro-optical converter EO3 for converting the electrical radio frequency carrier signal into an optical radio frequency carrier signal using an optical source with f_{optical} being the frequency of the light of the optical source, so that the optical radio frequency carrier signal has a frequency f_{orf} = f_{optical} ± f_{rf}.

From the output of the third electro-optical converter EO3, the optical radio frequency carrier signal is sent over an optical connection to the second input of the optical adder A1.

In the optical adder A1, the digital optical data signal is added with the optical radio frequency carrier signal, i.e. the digital optical data signal with the frequency fₒₛ = f_{optical} ± f_{bb} is summed up with the optical radio frequency carrier signal with the frequency f_{orf} = f_{optical} ± f_{rf}, which results in combined optical data signals.

From the output of the optical adder A1, the combined optical data signals are sent over the optical connection OF2, which can be e.g. an optical fiber or an optical free-space connection, to an input of the first opto-electrical converter OE1.

In the first opto-electrical converter OE1, the principle of optical heterodyning is applied, and the digital optical data signal is upconverted into a digital electrical data signal. The intensity of the detected digital electrical data signal varies with a frequency f_{des} = f_{rf} ± f_{bb}, as all higher frequency components of the intensity in the range of f_{optical} are time averaged in the first opto-electrical converter OE1.

Preferably, said opto-electrical converter OE1 comprises a so-called PIN-diode or a so-called avalanche-photo-diode.

In an embodiment of the invention, the digital electrical data signal is not upconverted on a radio frequency using optical heterodyning, but by means of electrical upconversion on the radio frequency before the first electro-optical converter EO1. In the first electro-optical converter EO1, the digital electrical data signal on radio frequency level is then converted into a digital optical signal, and directly transmitted via the optical connection OF2 to the input of the opto-electrical converter OE1.

The digital electrical data signal is sent from an output of the first opto-electrical converter OE1 to an input of the first analogue reconstruction device AR1 in which the analogue electrical data signal is recovered. Said first analogue reconstruction device AR1 can e.g. be a so-called reconstruction filter in case of delta sigma modulated or pulse width modulated electrical digital data signals.

The analogue electrical data signal is sent from the output of the first analogue reconstruction device AR1 to the first input of the analogue radio frequency power amplifier PA for amplification. The analogue electrical data signal controls the first input of the analogue radio frequency power amplifier PA, whereas the amplified analogue electrical envelope signal component is connected as a supply voltage to the second input of the analogue radio frequency power amplifier PA, which leads to an amplified copy of the amplitude and phase modulated baseband signal at the output of the analogue radio frequency power amplifier PA.

The amplified electrical analogue data signals are filtered in the antenna filter AF, and sent to the antenna network AN for transmission over an air interface. The antenna filter AF blocks the unwanted spectral fractions, i.e. the out-of-band fractions, of the signal and passes the desired spectral fraction, i.e. the in-band fraction, of the signal to the antenna. Said antenna filter can e.g. be a bandpass filter with suitable frequency characteristic and matching performance.

In the following, two alternative embodiments are described for linearization of the analogue radio frequency power amplifier PA, which are both depicted in fig. 2.

In an embodiment of the invention, the transmitting device BS further comprises a mixer M1, a second carrier synthesizer CS2, and a third opto-electrical converter OE3, and the receiving device RAH1 further comprises an analogue-to-digital converter AD, and a fourth electro-optical converter E04.

The embodiment for linearization of the analogue radio frequency power amplifier PA is based on a digitalization of a sample of the amplified electrical analogue data signals followed by a conversion to the optical domain. In a first alternative, which is indicated by a) and d), the electrical analogue data signals are tapped directly after the analogue radio frequency power amplifier PA and fed to the analogue-to-digital converter AD, in which the electrical analogue data signals are converted into electrical digital data signals. In a second alternative, which is indicated by b) and d), the electrical analogue data signals are tapped after the antenna filter AF and fed to the analogue-to-digital converter AD, in which the electrical analogue data signals are converted into electrical digital data signals.

Afterwards the electrical digital data signals are converted into optical digital data signals in the fourth electro-optical converter E04, and are transmitted via an optical connection OF3, as e.g. an optical fiber or an optical free-space connection to the third opto-electrical converter OE3 located in the transmitting device BS, in which the optical digital data signals are converted back into electrical digital data signals. Then the electrical digital data signals are sent via a reconstruction filter, which is not shown in fig. 2, to the mixer M1 in which they are downconverted to baseband level by means of electrical analogue radio frequency carrier signals generated in the second carrier synthesizer CS2. Finally, the downconverted electrical analogue data signals are fed to the digital signal processing unit DPU for baseband linearization. The digital signal processing unit DPU in this embodiment additionally comprises an anti-aliasing filter and an analogue-to-digital converter, which are not shown in fig. 2, for filtering and conversion into the digital domain of the downconverted electrical analogue data signals. In a variant of the embodiment, not the tapped electrical analogue data signals are transmitted back to the digital signal processing unit DPU, but merely a control information for baseband linearization which has been calculated in the receiving device RAH1.

In a further variant of the embodiment, the electrical digital data signals are not sent via a reconstruction filter, but directly to the mixer M1 in which they are downconverted to baseband level by means of electrical digital radio frequency carrier signals generated in the second carrier synthesizer CS2. Finally, the downconverted electrical digital data signals are fed to the digital signal processing unit DPU for baseband linearization.

In another embodiment of the invention, the receiving device RAH1 further comprises two matching lines ML1, ML2, and a linearization device LIN.

The embodiment is based on a linearization on a radio frequency level. In a first alternative, which is indicated by a) and c), the electrical analogue data signals are tapped directly after the analogue radio frequency power amplifier PA and fed to the linearization device LIN via a first suitable interface adaptation, as e.g. the first matching line ML1. Based on the measured deviation of the electrical analogue data signals from the theoretical ideally, i.e. linearly, amplified signal the linearization device LIN derives a compensation signal which is then fed to the input of the analogue radio frequency power amplifier PA again via a second suitable interface adaptation, as e.g. the second matching line ML2, resulting in linearity-improved overall output signals. The matching lines ML1 and ML2 need to be designed carefully considering frequency and phase characteristics of the signal. Said linearization device LIN can e.g. be a fast differential amplifier with suitable characteristic which is driven by the scaled input and output signal of the analogue radio frequency power amplifier PA. In a second alternative, which is indicated by b) and c), the electrical analogue data signals are tapped after the antenna filter AF and fed to the linearization device LIN via the first suitable interface adaptation, as e.g. the first matching line ML1. As in the first alternative described above, the electrical analogue data signals are conditioned in the linearization device LIN and then fed to the input of the analogue radio frequency power amplifier PA again via a second suitable interface adaptation, as e.g. the second matching line ML2, resulting in a linearity-improved overall output signal.

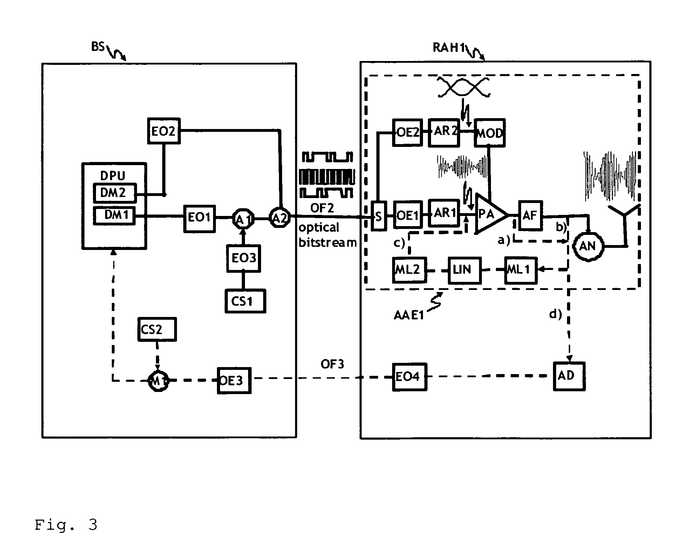

Fig. 3 schematically shows a transmitting device comprising digital modulators linked by a common optical connection serving as both envelope signal path and data signal path with a receiving device comprising an analogue radio frequency power amplifier according to the invention. The principle structure is similar to the one depicted in fig. 2, so that only the differences are described in the following.

Compared to the embodiment depicted in fig. 2, the transmitting device BS depicted in fig. 3 additionally comprises a second optical adder A2. Furthermore, compared to the embodiment depicted in fig. 2, the receiving device RAH1 additionally comprises an optical splitter S.

An output of the first optical adder A1 is connected to a first input of the second optical adder A2, and an output of the second electro-optical converter E02 is connected to a second input of the second optical adder A2.

An output of the second optical adder A2 is connected to an input of the optical splitter S through an optical connection OF2, as e.g. an optical fiber or an optical free-space connection.

A first output of the optical splitter S is connected to the input of the first opto-electrical converter OE1, and a second output of the optical splitter OS is connected to the input of the second opto-electrical converter OE2.

In the second electro-optical converter E02, the electrical digital envelope signal component is converted into a digital optical signal using an optical source with the frequency of the light f' _{optical} of the optical source being different from the frequency of the light f_{optical} of the optical source of the first electro-optical converter EO1, so that the digital optical envelope signal component has a frequency f'ₒₛ = f'_{optical} ± f'_{bb'} with f'_{bb} being the baseband frequency of the electrical digital envelope signal component on baseband level.

In the second optical adder A2, the digital optical data signal with the frequency fₒₛ = f_{optical} ± f_{bb} and the optical radio frequency carrier signal with the frequency f_{orf} = f_{optical} ± f_{rf}, which have been summed up in the first optical adder A1, are summed up with the digital optical envelope signal component with the frequency f'ₒₛ = f'_{optical} ± f'_{bb'} which results in combined optical data signals.

From the output of the second optical adder A2, the combined optical data signals are sent over the optical connection OF2, which can be e.g. an optical fiber or an optical free-space connection, to an input of the optical splitter S located in the receiving device RAH1.

In the optical splitter S, the digital optical data signal with the frequency fₒᵣ = f_{optical} ± f_{bb} and the optical radio frequency carrier signal with the frequency f_{orf} = f_{optical} ± f_{rf} are separated from the digital optical envelope signal component with the frequency f'ₒₛ = f'_{optical} ± f'_{bb} based on the optical carrier wavelength and transmitted to the input of the first opto-electrical converter OE1 and the input of the second opto-electrical converter OE2 respectively.

The further processing of the two sets of optical digital data signals is as described above in fig. 2.

In a further embodiment of the invention, signals from the base station BS are transmitted through at least two optical connections OF5, OF6 via at least two remote antenna heads RAH3, RAH4 to a user terminal UE4 applying so-called beamforming or multiple-input-multiple-output, as depicted in fig. 1 for the case of two remote antenna heads RAH3 and RAH4 that are used for signal transmission to the user terminal UE4.

In the embodiments above, the invention is described for the transmission of signals from a base station BS via at least one remote antenna head RAH1 to a user terminal UE1, however the invention is also applicable for transmission of signals from an arbitrary transmitting device to an arbitrary receiving device, as e.g. used in a point-to-point radio system or used for connection of devices within a rack.

## Claims

1. A method for transmission of data signals from a transmitting device (BS) to at least one receiving device (RAH1) comprising at least one analogue radio frequency power amplifier (PA) using envelope tracking for signal amplification, wherein
• the data signals are represented by electrical digital envelope signal components and electrical digital data signals in the transmitting device (BS),
• the electrical digital envelope signal components and electrical digital data signals are
- converted from electrical digital signals into optical digital signals in at least one electro-optical converter (EO1, E02) located in the transmitting device (BS),
- transmitted over at least one optical connection (OF1, OF2) from the transmitting device (BS) to the at least one receiving device (RAH1),
- and converted into electrical digital signals in at least one opto-electrical converter (OE1, OE2) located in the at least one receiving device (RAH1),
• the electrical digital envelope signals components and the electrical digital data signals are converted into electrical analogue envelope signal components and electrical analogue data signals in at least one analogue reconstruction device (AR1, AR2) located in the at least one receiving device (RAH1),
• a supply voltage is modulated with the electrical analogue envelope signal components in at least one modulator (MOD) located in the at least one receiving device (RAH1),
• and the data signals are amplified in said at least one analogue radio frequency power amplifier (PA) driven by said supply voltage.

2. A method according to claim 1, wherein
• electrical radio frequency carrier signals are converted into optical radio frequency carrier signals in a further electro-optical converter (EO3) in the transmitting device (BS),
• the optical digital data signals are transmitted together with the optical radio frequency carrier signals as combined optical signals to the at least one receiving device (RAH1),
• and the optical digital data signals are upconverted into the electrical digital data signals applying optical heterodyning in the at least one opto-electrical converter (OE1) located in the at least one receiving device (RAH1).

3. A method according to any of the preceding claims, wherein electrical envelope signal components and electrical data signals are modulated in at least one digital modulator (DM1, DM2) by means of one of the group of delta sigma modulation, 1 bit analogue to digital conversion and pulse length modulation resulting in the electrical digital envelope signal components and the electrical digital data signals.

4. A method according to any of the preceding claims, wherein the at least one analogue reconstruction device (AR1, AR2) is at least one reconstruction filter.

5. A method according to any of the preceding claims, wherein the at least one analogue radio frequency power amplifier (PA) is at least one of the group of Class-AB amplifier, Class-E amplifier, Class-F amplifier, and Doherty amplifier

6. A method according to any of the preceding claims, wherein said transmitting device (BS) is a base station and said at least one receiving device (RAH1) is a remote antenna head, and said data signals are transmitted from the base station (BS) via the at least one remote antenna head (RAH1) to a user terminal (UE1).

7. A method according to any of the preceding claims, wherein data signals from the base station (BS) are transmitted via at least two remote antenna heads (RAH3, RAH4) to a user terminal (UE4) applying beamforming or multiple-input-multiple-output.

8. A method according to any of the preceding claims, wherein a sample of an electrical analogue output signal of the at least one analogue radio frequency power amplifier (PA) is fed back via a linearization device (LIN), in which the electrical analogue output signal is conditioned for linearization on radio frequency level, to the input of the at least one analogue radio frequency power amplifier (PA) .

9. A method according to any of the preceding claims, wherein
• a sample of an electrical analogue output signal of the at least one analogue radio frequency power amplifier (PA) is digitized in an analogue-to-digital converter (AD) and converted into an optical digital output signal in an electro-optical converter (E04),
• the optical digital output signal is transmitted over an optical connection (OF3) from the at least one receiving device (RAH1) to the transmitting device (BS),
• the optical digital output signal is converted into an electrical digital output signal in an opto-electrical converter (OE3), downconverted into baseband level in a downconverter (M1) and fed to a digital signal processing unit (DPU) for baseband linearization.

10. A receiving device (RAH1) for reception of signals sent from a transmitting device (BS) and using envelope tracking for signal amplification wherein said receiving device (RAH1) comprises
• at least one optical input that is adapted to receive data signals represented by optical digital envelope signal components and optical digital data signals,
• at least one opto-electrical converter (OE1, OE2) that is adapted to convert the optical digital envelope signal components and optical digital data signals into electrical digital signal components and electrical digital data signals, envelope
• at least one analogue reconstruction device (AR1, AR2) that is adapted to convert the electrical digital envelope signal components and electrical digital data signals into electrical analogue envelope signal components and electrical analogue data signals,
• at least one modulator (MOD) that is adapted to modulate a supply voltage with said electrical analogue envelope signal components,
• and at least one analogue radio frequency power amplifier (PA) that is adapted to be driven by said supply voltage to amplify said electrical analogue data signals.

11. A receiving device (RAH1) according to claim 10, wherein said receiving device (RAH1) is a remote antenna head for reception of signals sent from a base station (BS) and used for a communication network (CN) applying the standard Universal Mobile Telecommunications System, Third Generation Partnership Project Long Term Evolution, Third Generation Partnership Project Long Term Evolution Advanced, or Worldwide Interoperability for Microwave Access.

12. A communication network (CN) comprising at least one base station (BS) for transmission of signals to at least one receiving device (RAH1) wherein said base station (BS) comprises
- at least one digital modulator (DM1, DM2) that is adapted to digitally modulate electrical envelope signal components and electrical data signals resulting in electrical digital envelope signal components and electrical digital data signals,
- at least one electro-optical converter (EO1, EO2) that is adapted to convert at least one of the group of the electrical digital envelope signal components and the electrical digital data signals into optical digital signals,
- and at least one optical output for transmission of said optical digital signals,
and at least one remote antenna head (RAH1) according to claim 11 for transmission of signals from said at least one base station (BS) via said at least one remote antenna head (RAH1) to a user terminal (UE1).

## Patentansprüche

1. Verfahren zur Übertragung von Datensignalen von einer Sendevorrichtung (BS) an mindestens eine Empfangsvorrichtung (RAH1) mit mindestens einem analogen Funkfrequenz-Leistungsverstärker (PA) unter Verwendung der Hüllkurvenverfolgung zur Signalverstärkung, wobei
• die Datensignale durch digitale elektrische Hüllkurvensignalkomponenten und digitale elektrische Datensignale in der Sendevorrichtung (BS) dargestellt werden,
• die digitalen elektrischen Hüllkurvensignalkomponenten und die digitalen elektrischen Datensignale
- in mindestens einem in der Sendevorrichtung (BS) angeordneten elektro-optischen Wandler (E01, E02) von digitalen elektrischen Signalen in digitale optische Signale umgewandelt werden,
- über mindestens eine optische Verbindung (OF1, OF2) von der Sendevorrichtung (BS) an die mindestens eine Empfangsvorrichtung (RAH1) übertragen werden,
- und in mindestens einem in der mindestens einen Empfangsvorrichtung (RAH1) angeordneten opto-elektrischen Wandler (OE1, OE2) in digitale elektrische Signale umgewandelt werden,
• die digitalen elektrischen Hüllkurvensignalkomponenten und die digitalen elektrischen Datensignale in mindestens einer in der mindestens einen Empfangsvorrichtung (RAH1) angeordneten analogen Rekonstruktionsvorrichtung (AR1, AR2) in analoge elektrische Hüllkurvensignalkomponenten und analoge elektrische Datensignale umgewandelt werden,
• eine Versorgungsspannung in mindestens einem in der mindestens einen Empfangsvorrichtung (RAH1) angeordneten Modulator (MOD) mit den analogen elektrischen Hüllkurvensignalkomponenten moduliert wird,
• und die Datensignale in dem besagten mindestens einen von der besagten Versorgungsspannung angetriebenen analogen Funkfrequenz-Leistungsverstärker (PA) verstärkt werden.

2. Verfahren nach Anspruch 1, wobei
• elektrische Funkfrequenzträgersignale in einem weiteren elektro-optischen Wandler (EO3) in der Sendevorrichtung (BS) in optische Funkfrequenzträgersignale umgewandelt werden,
• die digitalen optischen Datensignale zusammen mit den optischen Funkfrequenzträgersignalen als kombinierte optische Signale an die mindestens eine Empfangsvorrichtung (RAH1) übertragen werden,
• und die digitalen optischen Datensignale durch Anwenden einer optischen Überlagerung in dem mindestens einen opto-elektrischen Wandler (OE1), welcher in der mindestens einen Empfangsvorrichtung (RAH1) angeordnet ist, in die digitalen elektrischen Datensignale aufwärts umgewandelt werden.

3. Verfahren nach einem beliebigen der vorstehenden Ansprüche, wobei elektrische Hüllkurvensignalkomponenten und elektrische Datensignale in mindestens einem digitalen Modulator (DM1, DM2) anhand einer der Gruppe bestehend aus Delta-Sigma-Modulation, 1-Bit-Analog-zu-Digital-Umwandlung und Pulslängenmodulation moduliert werden, um die digitalen elektrischen Hüllkurvensignalkomponenten und die digitalen elektrischen Datensignale zu erhalten.

4. Verfahren nach einem beliebigen der vorstehenden Ansprüche, wobei die mindestens eine analoge Rekonstruktionsvorrichtung (AR1, AR2) mindestens ein Rekonstruktionsfilter ist.

5. Verfahren nach einem beliebigen der vorstehenden Ansprüche, wobei der mindestens eine analoge Funkfrequenz-Leistungsverstärker (PA) einer der Gruppe bestehend aus Klasse-AB-Verstärker, Klasse-E-Verstärker, Klasse-F-Verstärker und Doherty-Verstärker ist.

6. Verfahren nach einem beliebigen der vorstehenden Ansprüche, wobei die besagte Sendevorrichtung (BS) eine Basisstation ist, und die besagte mindestens eine Empfangsvorrichtung (RAH1) ein entfernter Antennenkopf ist, und wobei die besagten Datensignale über den mindestens einen entfernten Antennenkopf (RAH1) von der Basisstation (BS) an ein Benutzerendgerät (UE1) übertragen werden.

7. Verfahren nach einem beliebigen der vorstehenden Ansprüche, wobei Datensignale von der Basisstation (BS) über mindestens zwei entfernte Antennenköpfe (RAH3, RAH4) an ein Benutzerendgerät (UE4) unter Anwendung des Beamforming- oder Multi-Input-Multi-Output-Verfahrens übertragen werden.

8. Verfahren nach einem beliebigen der vorstehenden Ansprüche, wobei ein Abtastwert eines analogen elektrischen Ausgangssignals des mindestens einen analogen Funkfrequenz-Leistungsverstärkers (PA) über eine Linearisierungsvorrichtung (LIN), in welcher das analoge elektrische Ausgangssignal für die Linearisierung auf Funkfrequenzebene konditioniert wird, an den Eingang des mindestens einen analogen Funkfrequenz-Leistungsverstärkers (PA) rückgekoppelt wird.

9. Verfahren nach einem beliebigen der vorstehenden Ansprüche, wobei
• ein Abtastwert eines analogen elektrischen Ausgangssignals des mindestens einen analogen Funkfrequenz-Leistungsverstärkers (PA) in einem Analog-zu-Digital-Wandler (AD) digitalisiert und in einem elektro-optischen Wandler (E04) in ein digitales optisches Ausgangssignal umgewandelt wird,
• das digitale optische Ausgangssignal über eine optische Verbindung (OF3) von der mindestens einen Empfangsvorrichtung (RAH1) an die Sendevorrichtung (BS) übertragen wird,
• das digitale optische Ausgangssignal in einem opto-elektrischen Wandler (OE3) in ein digitales elektrisches Ausgangssignal umgewandelt, in einem Abwärtswandler (M1) in die Basisbandebene abwärts umgewandelt und zur Basisband-Linearisierung an eine digitale Signalverarbeitungseinheit (DPU) rückgekoppelt wird.

10. Empfangsvorrichtung (RAH1) für den Empfang von Signalen, die von einer Sendevorrichtung (BS) gesendet werden, und für die Verwendung der Hüllkurvenverfolgung zur Signalverstärkung, wobei die besagte Empfangsvorrichtung (RAH1) umfasst:
• Mindestens einen optischen Eingang, welcher für den Empfang von Datensignalen, die durch digitale optische Hüllkurvensignalkomponenten dargestellt werden, und von digitalen optischen Datensignalen ausgelegt ist,
• mindestens einen opto-elektrischen Wandler (OE1, OE2), welcher für das Umwandeln der digitalen optischen Hüllkurvensignalkomponenten und der digitalen optischen Datensignale in digitale elektrische Hüllkurvensignalkomponenten und digitale elektrische Datensignale ausgelegt ist,
• mindestens eine analoge Rekonstruktionsvorrichtung (AR1, AR2), welche für das Umwandeln der digitalen elektrischen Hüllkurvensignalkomponenten und der digitalen elektrischen Datensignale in analoge elektrische Hüllkurvensignalkomponenten und analoge elektrische Datensignale ausgelegt ist,
• mindestens einen Modulator (MOD), welcher für das Modulieren einer Versorgungsspannung mit den besagten analogen elektrischen Hüllkurvensignalkomponenten ausgelegt ist,
• und mindestens einen analogen Funkfrequenz-Leistungsverstärker (PA), welcher dazu ausgelegt ist, von der besagten Versorgungsspannung angetrieben zu werden, um die besagten analogen elektrischen Datensignale zu verstärken.

11. Empfangsvorrichtung (RAH1) gemäß Anspruch 10, wobei die besagte Empfangsvorrichtung (RAH1) ein entfernter Antennenkopf für den Empfang von von einer Basisstation (BS) gesendeten Signalen ist und für ein Kommunikationsnetzwerk (CN), welches Standard Universal Mobile Telecommunications System, Third Generation Partnership Project Long Term Evolution, Third Generation Partnership Project Long Term Evolution Advanced, oder Worldwide Interoperability for Microwave Access anwendet, verwendet wird.

12. Kommunikationsnetzwerk (CN) mit mindestens einer Basisstation (BS) für die Übertragung von Signalen an mindestens eine Empfangsvorrichtung (RAH1), wobei die besagte Basisstation (BS) umfasst:
- Mindestens einen digitalen Modulator (DM1, DM2), welcher dazu ausgelegt ist, elektrische Hüllkurvensignalkomponenten und elektrische Datensignale digital zu modulieren, um digitale elektrische Hüllkurvensignalkomponenten und digitale elektrische Datensignale zu erhalten,
- mindestens einen elektro-optischen Wandler (E01, E02), welcher dazu ausgelegt ist, mindestens eine der Gruppe von digitalen elektrischen Hüllkurvensignalkomponenten und die digitalen elektrischen Datensignale in digitale optische Signale umzuwandeln,
- und mindestens einen optischen Ausgang für die Übertragung der besagten digitalen optischen Signale,
- und mindestens einen entfernten Antennenkopf (RAH 1) gemäß Anspruch 11 für die Übertragung von Signalen über den besagten mindestens einen entfernten Antennenkopf (RAH1) von mindestens einer Basisstation (BS) an ein Benutzerendgerät (UE1).

## Revendications

1. Procédé de transmission de signaux de données depuis un dispositif émetteur (BS) vers au moins un dispositif récepteur (RAH1) comprenant au moins un amplificateur de puissance (PA) en radiofréquence analogique employant le suivi d'enveloppe pour l'amplification du signal, procédé selon lequel
• les signaux de données sont représentés par des composantes de signal d'enveloppe numériques électriques et des signaux de données numériques électriques dans le dispositif émetteur (BS),
• les composantes de signal d'enveloppe numériques électriques et les signaux de données numériques électriques sont
- convertis de signaux numériques électriques en signaux numériques optiques dans au moins un convertisseur électro-optique (EO1, E02) qui se trouve dans le dispositif émetteur (BS),
- transmis sur au moins une connexion optique (OF1, OF2) du dispositif émetteur (BS) vers l'au moins un dispositif récepteur (RAH1),
- et convertis en signaux numériques électriques dans au moins un convertisseur opto-électrique (OE1, OE2) qui se trouve dans l'au moins un dispositif récepteur (RAH1),
• les composantes de signal d'enveloppe numériques électriques et les signaux de données numériques électriques sont convertis en composantes de signal d'enveloppe analogiques électriques et en signaux de données analogiques électriques dans au moins un dispositif de reconstruction analogique (AR1, AR2) qui se trouve dans l'au moins un dispositif récepteur (RAH1),
• une tension d'alimentation est modulée avec les composantes de signal d'enveloppe analogiques électriques dans au moins un modulateur (MOD) qui se trouve dans l'au moins un dispositif récepteur (RAH1),
• et les signaux de données sont amplifiés par ledit au moins un amplificateur de puissance (PA) en radiofréquence analogique piloté par ladite tension d'alimentation.

2. Procédé selon la revendication 1, selon lequel
• les signaux de porteuse en radiofréquence électriques sont convertis en signaux de porteuse en radiofréquence optiques dans un convertisseur électro-optique (E03) supplémentaire dans le dispositif émetteur (BS),
• les signaux de données numériques optiques sont transmis conjointement avec les signaux de porteuse en radiofréquence optiques sous la forme de signaux combinés vers l'au moins un dispositif récepteur (RAH1),
• et les signaux de données numériques optiques sont surconvertis en les signaux de données numériques électriques en appliquant une transposition en fréquence optique dans l'au moins un convertisseur opto-électrique (OE1) qui se trouve dans l'au moins un dispositif récepteur (RAH1).

3. Procédé selon l'une quelconque des revendications précédentes, selon lequel les composantes de signal d'enveloppe électriques et les signaux de données électriques sont modulés dans au moins un modulateur numérique (DM1, DM2) au moyen d'au moins une méthode du groupe composé de la modulation sigma delta, de la conversion analogique/numérique 1 bit et de la modulation d'impulsion en longueur, ce qui produit les composantes de signal d'enveloppe numériques électriques et les signaux de données numériques électriques.

4. Procédé selon l'une quelconque des revendications précédentes, selon lequel l'au moins un dispositif de reconstruction analogique (AR1, AR2) est au moins un filtre de reconstruction.

5. Procédé selon l'une quelconque des revendications précédentes, selon lequel l'au moins un amplificateur de puissance (PA) en radiofréquence analogique est au moins l'un du groupe composé d'un amplificateur de classe AB, amplificateur de classe E, amplificateur de classe F et amplificateur Doherty.

6. Procédé selon l'une quelconque des revendications précédentes, selon lequel ledit dispositif émetteur (BS) est une station de base et ledit au moins un dispositif récepteur (RAH1) est une tête d'antenne distante et lesdits signaux de données sont transmis de la station de base (BS) à un terminal d'utilisateur (UE1) par le biais de ladite au moins une tête d'antenne distante (RAH1).

7. Procédé selon l'une quelconque des revendications précédentes, selon lequel les signaux de données provenant de la station de base (BS) sont transmis à un terminal d'utilisateur (UE4) par le biais d'au moins deux têtes d'antenne distantes (RAH3, RAH4) en appliquant la conformation de faisceau ou l'entrée multiple - sortie multiple.

8. Procédé selon l'une quelconque des revendications précédentes, selon lequel un échantillon d'un signal de sortie analogique électrique de l'au moins un amplificateur de puissance (PA) en radiofréquence analogique est renvoyé par le biais d'un dispositif de linéarisation (LIN), dans lequel le signal de sortie analogique électrique est conditionné pour une linéarisation au niveau de la radiofréquence, vers l'entrée de l'au moins un amplificateur de puissance (PA) en radiofréquence analogique.

9. Procédé selon l'une quelconque des revendications précédentes, selon lequel
• un échantillon d'un signal de sortie analogique électrique de l'au moins un amplificateur de puissance (PA) en radiofréquence analogique est numérisé dans un convertisseur analogique/numérique (AD) puis converti en un signal de sortie numérique optique dans un convertisseur électro-optique (E04),
• le signal de sortie numérique optique est transmis sur une connexion optique (OF3) depuis l'au moins un dispositif récepteur (RAH1) vers le dispositif émetteur (BS),
• le signal de sortie numérique optique est converti en un signal de sortie numérique électrique dans un convertisseur opto-électrique (OE3), sous-converti en niveau de la bande de base dans un sous-convertisseur (M1), puis acheminé à une unité de traitement de signal numérique (DPU) pour sa linéarisation en bande de base.

10. Dispositif récepteur (RAH1) pour la réception de signaux envoyés depuis un dispositif émetteur (BS) et employant le suivi d'enveloppe pour l'amplification du signal, avec lequel ledit dispositif de réception (RAH1) comprend
• au moins une entrée optique qui est adaptée pour recevoir des signaux de données représentés par des composantes de signal d'enveloppe numériques optiques et des signaux de données numériques optiques,
• au moins un convertisseur opto-électrique (OE1, OE2) qui est adapté pour convertir les composantes de signal d'enveloppe numériques optiques et les signaux de données numériques optiques en composantes de signal d'enveloppe numériques électriques et en signaux de données numériques électriques,
• au moins un dispositif de reconstruction analogique (AR1, AR2) qui est adapté pour convertir les composantes de signal d'enveloppe numériques électriques et les signaux de données numériques électriques en composantes de signal d'enveloppe analogiques électriques et en signaux de données analogiques électriques,
• au moins un modulateur (MOD) qui est adapté pour moduler une tension d'alimentation avec lesdites composantes de signal d'enveloppe analogiques électriques,
• et au moins un amplificateur de puissance (PA) en radiofréquence analogique qui est adapté pour être piloté par ladite tension d'alimentation pour amplifier lesdits signaux de donnée analogiques électriques.

11. Dispositif récepteur (RAH1) selon la revendication 10, avec lequel le dispositif récepteur (RAH1) est une tête d'antenne distante pour la réception de signal émis depuis une station de base (BS) et utilisé pour un réseau de communication (CN) appliquant le système de télécommunications mobile universel standard, l'évolution à long terme du projet de partenariat de troisième génération, l'évolution à long terme du projet de partenariat de troisième génération avancé ou l'interopérabilité mondiale des accès d'hyperfréquence.

12. Réseau de communication (CN) comprenant au moins une station de base (BS) pour la transmission de signaux vers au moins un dispositif récepteur (RAH1), avec lequel ladite station de base (BS) comprend
- au moins un modulateur numérique (DM1, DM2) qui est adapté pour moduler numériquement les composantes de signal d'enveloppe électriques et les signaux de données électriques résultant en des composantes de signal d'enveloppe numériques électriques et des signaux de données numériques électriques,
- au moins un convertisseur électro-optique (EO1, E02) qui est adapté pour convertir au moins l'une parmi le groupe des composantes de signal d'enveloppe numériques électriques et signaux de données numériques électriques en signaux numériques optiques,
- et au moins une sortie optique pour la transmission desdits signaux numériques optiques,
et au moins une tête d'antenne distante (RAH1) selon la revendication 11 pour la transmission de signaux depuis ladite au moins une station de base (BS) à un terminal d'utilisateur (UE1) par l'intermédiaire de ladite au moins une tête d'antenne distante (RAH1).
